# EUROPEAN PATENT APPLICATION

(11) **EP 0 568 841 A1**
(43) Date of publication of application: **10.11.1993**
(21) Application number: 93106052.9
(22) Date of filing: 14.04.1993
(51) Int. Cl.: G03F 1/00, G03F 7/004, G03F 7/095

(54) **Process of photoimaging using ink jet printing**

(30) Priority: 07.05.1992 US 880089
(71) Applicant: E.I. DU PONT DE NEMOURS AND COMPANY, Wilmington Delaware 19898 (US)
(72) Inventor: Ma, Sheau-Hwa, Chadds Ford, Pennsylvania 19317 (US); Felton, John J., Chapel Hill, North Carolina 27709 (US)
(74) Representative: von Kreisler, Alek, Dipl.-Chem.

(57) **Abstract**

A process of photoimaging a photosensitive element comprises the steps of applying a photosensitive layer to a support; generating an actinic radiation-opaque, pigmented ink jet ink image layer on the photosensitive layer by ink jet printing, wherein the ink does not react with or substantially penetrate into the photosensitive layer; exposing the photosensitive layer to actinic radiation through the image layer; and developing to form an image. Optionally, a cover sheet may be applied to the photosensitive layer and the image layer generated on the cover sheet.

## Description

### FIELD OF THE INVENTION

This invention relates to photoimaging and, more particularly, to a process of photoimaging a photosensitive element, wherein an opaque image layer is generated direcly on a photosensitive element using ink jet printing and pigmented ink jet inks.

### BACKGROUND OF THE INVENTION

The use of photomasks to image photosensitive elements is well known in the art. Typically, the photomask is generated by image-wise exposing a photosensitive layer, such as diazo, electrographic, silver halide, photopolymer films, etc., which is then processed to produce a radiation-opaque image photomask. The photosensitive element is then irradiated through the photomask, whereby the photomask blocks or modulates the radiation and thus controls the exposure of the photosensitive element.

In the abovementioned method, the photomask is a separate photosensitive element comprising a photosensitive layer coated or laminated on a support. During exposure, the photomask is usually maintained in intimate contact with the photosensitive element in a vacuum frame. It is a critical requirement in high resolution imaging for the photomask to be in close contact with the photosensitive element. The time needed to achieve the required contact is relatively long, and is usually the slowest step in the entire image making process. Additional problems can also arise in using a separate photomask, particularly in imaging photopolymer layers which are tacky. In such circumstances, it is often necessary to incorporate a matting agent into the photomask and/or the photosensitive layer to minimize adhesion of the photomask to the tacky photosensitive layer.

It is also known in the art that the above-mentioned disadvantages can be avoided by using a photomask layer directly on the photsensitive element (so-called "integral photomasks"). For example, U.S. Patent 4,429,027 teaches a method wherein a integral photomask is obtained by transfer of a toned image onto the photosensitive element. In essence, this method comprises forming a latent image on a temporary master, toning the image, and then printing the toned image on the photosensitve element to form the integral photomask. An alternate method disclosed by this reference comprises forming the photomask on the photosensitive element by laser imaging of an opaque thermal release layer, followed by peeling of the release layer.

Although the methods taught by the aforementioned U.S. Patent offer improvement over the separate Photomask technique, they are not without their disadvantages. For example, all but one of the methods taught therein require separate steps to generate the image which is then used to make the photomask, such as exposure to form a latent image, toning the latent image, and transfer to the photosensitive element. In only one of the disclosed methods is the photomask formed directly on the photosensitive element, but that method is limited to particular photosensitive elements and expensive laser imaging techniques..

It has been proposed in the art to use ink jet printing technology to make integral photomasks. Japanese Laid-Open Application (Kokai) 62-54253, for example, teaches a method of relief formation wherein an aqueous colored ink is applied to a water-soluble photohardenable layer with an ink jet printer, followed by irradiation and wash-off development with water or alkaline water. In this method, the aqueous inks contain water soluble organic dyes which have poor lightfastness and tend to fade easily, especially under the ultraviolet irradiation which is most frequently used in exposing the photosensitive elements. Special water-soluble photohardenable layers with balanced hydrophobic/hydrophilic properties are required to allow the ink to penetrate into the photohardenable composition, whereby instead of blocking or modulating the irradiation on the surface of the photosensitive layer as a conventional photomask, the mask is only modulating the irradiation by competing with the photosensitive composition in the irradiation paths through the thickness of the photosensitive composition. As a result, this method does not produce an effective photomask as other prior art methods.

### SUMMARY OF THE INVENTION

The present invention is directed to a process of photoimaging a photosensitive element comprising the steps of:
(a) applying a photosensitive layer to a support;
(b) generating an actinic radiation-opaque image layer on said photosensitive layer with ink jet printing means, wherein said opaque image layer comprises a pigmented ink jet ink which does not react with or substantially penetrate into the photosensitive layer;
(c) exposing the photosensitive layer to actinic radiation through the opaque image layer; and
(d) developing the exposed photosensitive layer to form an image.

In another embodiment of the invention, a cover sheet is provided on the photosensitive layer and the opaque image is created on the cover sheet. It is preferred that the pigmented ink comprise an aqueous based ink jet ink and that the development step comprise washing with water.

### DETAILED DESCRIPTION OF THE INVENTION

Ink jet printing is a very attractive candidate as a process in computer driven patterning systems. It applies ink in very small drops allowing for high resolution image formation. It also has potential for high throughput, in very fast systems affording a deposition rate in excess of a million drops per second per nozzle. Further, ink jet systems are less expensive than any other currently available commercial system that allows high speed generation of patterns by bit mapped graphics.

The photosensitive element to be imaged comprises a support, a photosensitive layer and optionally a cover sheet. The opaque image layer is generated on the surface of the photosensitive layer or the cover sheet using ink jet printing and pigmented ink jet inks.

### SUPPORT

A wide range of supports are useful within the practice of the present invention, depending upon the particular application for the photosensitive element. Examples of useful supports including glass, cellulose triacetate, polyethylene terephthalate, polystyrene, polymerized acrylates, paper, cardboard, etc. Dimensionally stable polyester supports, such as polyethylene terephthalate are particularly preferred. In applications such as printing plates, solder masks and printed circuits, the supports may be opaque and contain metal or plastic. Typical supports for resist applications include combinations such as phenolic or epoxy resins on paper or a paper glass composites as well as polyester, epoxy, polyimide, polytetrafluoroethylene or polystyrene on glass. In most instances, these supports are also clad with a thin layer of electroconductive metal of which copper is by far the most common. Suitable supports for lithographic printing plates include those disclosed in U.S. 4,072,528 and U.S. 3,458,311.

### PHOTOSENSITIVE LAYER

The photosensitive layer may be chosen from a wide variety of diazo, silver halide, photopolymer, dielectric and electrographic films. Both positive and negative working photosensitive compositions are useful in practicing the invention. The photosensitive layer may be applied to the support by conventional techniques, such as screen printing, coating or lamination. Photo-sensitive layers which may be used to advantage in the present invention include those used in the examples herein. Other useful photosensitive compositions are well known to those skilled in the art, as exemplified by U.S. 3,261 686, U.S. 3,620,726, U.S. 3,649,268, U.S. 3,770,438, U.S. 3,854,950 and U.S. 4,174,216.

### COVER SHEET

Suitable cover sheets include polyethylene terephthalate, regenerated cellulose, cellulose triacetate, polyethylene, polypropylene, polyamide, polyvinyl alcohol, polyacrylate, etc. When certain types of oxygen sensitive photosensitive layers are employed, one particular function of the cover sheet is to provide an oxygen barrier to protect the underlying photosensitive layer. Where the photosensitive layer is tacky prior to or after exposure, the cover sheet is helpful to prevent the photosensitive layer from sticking to the ink jet pen. It is well within the skill of the ordinary artisan to know when cover sheets should be employed and when they are not desired.

The cover sheet, if used, is applied to the photosensitive layer by any well known technique. The image layer is then generated directly on the cover sheet.

### OPAQUE IMAGE LAYER

In accordance with the present invention, a pigmented ink is applied to the photosensitive layer (or to a cover sheet therefore) with an ink jet printing device to generate an original, integral photomask. The pigmented ink may be aqueous or solvent based. Preferably, the physical properties of the ink should be compatible with a wide range of ejecting conditions, i.e., driving voltage and pulse width for thermal ink jet printing devices, driving frequency of the piezo element for either a drop-on-demand device or a continuous device, and the shape and size of the nozzle, whereby they may be used with a variety of ink jet printers such as continuous, piezoelectric drop-on-demand and thermal or bubble jet drop-on-demand.

The image layer may be generated on the photosensitive element with an ink jet printhead similar to those found in commercially available ink jet printers of the type mentioned above.

It is a particular feature of the present invention that the pigmented ink and the photosensitive layer be compatible with one another such that the ink does not react with or substantially penetrate into the photosensitive layer. In the event that a cover sheet is employed, the ink should be one which is suitable for printing on the particular material used for the cover sheet.

### A) Aqueous based Inks

Aqueous pigmented ink jet inks comprise an aqueous carrier medium and a pigment dispersion. The aqueous carrier medium comprises water (preferably deionized water) or a mixture of water and at least one water soluble organic solvent such as polyhydric alcohols and their ether derivatives. The aqueous carrier medium is present as a major constituent of the ink composition, i.e., in the range of approximately 65 to 99%, preferably approximately 85 to 98.5% based on total weight of the ink.

Representative examples of water-soluble organic solvents are disclosed in US Patent 5,085,698, the disclosure of which is incorporated herein by reference. Selection of a suitable mixture of water and water soluble organic solvent depends upon the requirements of the specific application, such as desired surface tension and viscosity, drying time of the ink, and the type of photosensitive layer or cover sheet onto which the ink will be printed.

The aqueous carrier medium usually contains from about 5% to about 95% water, with the remainder (i.e., 95% to about 5%) being the water soluble organic solvent. The preferred ratios are approximately 60% to about 95% water, based on the total weight of the aqueous carrier medium. Higher concentrations of organic solvent may result in poor print quality. Lower concentrations will lead to drying out of the printhead or "crusting" of the ink. Cosolvents that are effective in keeping the active ingredients in solution and have high boiling point greater than 120°C can be useful in keeping the nozzles from clogging.

The inks of the present invention contain a pigment dispersion, which provides the ink with actinic radiation-opaque properties. The term pigment dispersion, as used herein, refers to a mixture of a pigment and a dispersing agent. Preferably, the dispersing agent is a polymeric dispersant compound. In addition to, or in place of the preferred polymeric dispersant compounds, anionic, cationic, nonionic, or amphoteric surfactants may be used. A detailed list of non-polymeric as well as some polymeric dispersants are listed in the section on dispersants, pages 110-129, 1990 McCutcheon's Functional Materials, North American Edition, Manufacturing Confection Publishing Co., Glen Rock, NJ, the disclosure of which is incorporated herein by reference.

Polymeric dispersants suitable for practicing the invention include random, block, and branched-type polymers. The polymer may be anionic, cationic or nonionic in nature. Random copolymers are not as effective in stabilizing pigment dispersions as the block polymers and, therefore, are not preferred.

A random polymer which has both hydrophilic segments for aqueous solubility and hydrophobic segments for interaction with pigment and an average molecular weight to contribute to the dispersion stability can be effectively used to practice the present invention. Inks useful in this invention that comprise such polymeric dispersants are disclosed in Ohta et al., U.S. Patent 4,597,794, issued July 1, 1986, the disclosure of which is incorporated herein by reference.

The block polymers suitable for practicing the invention include AS, BAB, and ABC type structures. A block polymer which has hydrophobic and hydrophilic blocks and balanced block sizes to contribute to the dispersion stability may be advantageously used to practice this invention. Functional groups can be built into the hydrophobic (pigment binding) block for stronger specific interactions between the pigment and the polymer dispersant to give an improved dispersion stability. Inks containing such block polymers are disclosed in U.S. Patent 5,085,690; U.S. Serial Number 07/839,533, filed February 20, 1992; and U.S. Serial Number 07/838,181 filed February 20, 1992, the disclosures of which are incorporated herein by reference. As mentioned in these references, it may be necessary to make salts of either the acid or amino groups contained in the polymer to render it soluble in the aqueous carrier medium.

The pigments need to be opaque and stable to the radiation used to expose the photosensitive layer. Useful pigments comprise a wide variety of organic and inorganic pigments, alone or in combination. The term "pigment" as used herein means an insoluble colorant. The pigment particles are sufficiently small to permit free flow of the ink through the ink jet printing device, especially at the ejecting nozzles that usually have a diameter ranging from 10 to 50 microns. The particle size also has an influence on the pigment dispersion stability, which is critical throughout the life of the ink. Brownian motion of minute particles will help prevent the particles from settling. Small particles are also desired for maximum optical density or maximum efficiency in modulating the radiation. The range of useful particle size is approximately 0.005 to 15 microns and most preferably, from 0.01 to 0.3 micron. Carbon black having an extremely broad absorption spectrum is the preferred pigment for the present invention.

The selected pigment may be used in either dry or wet (i.e., presscake) form. In presscake form, the pigment is not aggregated to the extent that it is in dry form and, thus, do not require as much deaggregation in the process of preparing the inks from dry pigments. Representative commercial dry and presscake pigments that may be used in practicing the invention are disclosed in the aforementioned US Patent 5,085,698. The pigment dispersions can be conveniently prepared by one skilled in the art using many conventional milling techniques such as media milling.

The ink needs to have a viscosity matching that of the printhead design to ensure smooth delivery of ink droplets. Useful viscosities for the typical printheads are below 20 cP, preferably below 10 cP at 20° C. Surface tension is an important property because it prevents the ink from dripping out of the nozzles and helps maintain droplet integrity to avoid splattering. Useful surface tension ranges from 20-80 dyne/cm, preferably 25-70 dynes/cm at 20° C.

### B) Solvent based Inks

The solvent based inks comprise a pigment dispersion and a solvent. Printing units equipped with printheads designed to handle such solvent systems are commercially available from, e.g. Videojet Systems, Division of A. B. Dick Company, Elk Grove Village, IL. The pattern generated with such inks is used as a photomask in the subsequent exposure step.

Useful solvents have reasonably high volatility so that the ink dries rapidly once ejected from the nozzles, low toxicity, and preferably do not have an offending odor. A solvent with high boiling point can be used in combination with the highly volatile solvent to prevent the nozzles from clogging during periods of non-use of the ink jet printer. Examples of useful solvents include:
(1) alcohols, such as methanol, ethanol, 1-propanol, 2-propanol, butanol, etc.,
(2) ketones such as methylethyl ketone, methyl isobutyl ketone, cyclohexanone, etc.,
(3) ethers such as ethyleneglycol monomethyl ether, ethyleneglycol monoethyl ether, ethyleneglycol diethyl ether, etc.,
(4) esters such as ethyl acetate, butyl acetate, etc.,
(5) aromatics such as benzene, toluene, xylene, etc., and
(6) chlorinated solvents such as methylene chloride, chloroform, carbon tetrachloride, ethylene dichloride, trichloroethylene, etc.

These organic solvents can be used alone or in combination with other organic solvents to optimize the ink properties such as viscosity, surface tension, etc., and performance features such as drying speed of ink after printing, print quality including dot shape and edge acuity, nozzle clogging, etc.

Solvent based pigment dispersions have been extensively used in many industrial applications including paints, plastic sheets, colored films, etc. The materials and procedures for preparing such dispersions are well known and have been described in the literature. Various polymers including random, block and branched types of polymers have been used to disperse the pigments. The important properties of the polymeric dispersant required for ink jet inks include good solubility in the chosen carrier medium, strong interaction with the pigment surface, and sufficient molecular weight to contribute to the dispersion stability. The molecular weight and the concentration of the polymer are useful parameters for controlling the viscosity of the final ink.

### EXPOSURE

After the image layer has been generated on the photosensitive element and dried, the element is exposed to actinic radiation through the image layer in the same manner as conventional photoimaging using non-integral photomasks. Any radiation source emitting radiation having the proper wavelength and adequate intensity can be used. Some suitable sources include mercury and mercury-xenon, carbon arc lamps, and other conventional ultraviolet, visible, or infrared sources.

The duration of the exposure, distance between the radiation source and the photosensitive element and other parameters involved in the exposure step will depend on the particular photosensitive material being exposed, the radiation source being used, the desired application or end use of the photosensitive element, etc. Such matters are well within the knowledge of the ordinary skilled artisan.

### DEVELOPMENT

After exposure, the photosensitive element is developed to form an image. The development step can be accomplished in accordance with methods well known in the art such as toning, heating, solvent washing, ammonia vapor treatment, dry peel-apart, diffusion transfer, color coupling, and the conventional silver halide emulsion processing steps of developing, fixing and washing.

In certain situations, it may be desired to have the image layer removed during the development step. If a cover sheet is employed over the photosensitive layer, this can be accomplished by simply removing the cover sheet prior to development. When the image layer is in intimate contact with the photosensitive layer (i.e., no cover sheet is used), the ink selected for use as the image layer needs to be compatible with the development chemistry in order for the ink to be conveniently removed during development. If, for example, a wet development step is employed, the selected ink should be soluble in the developer solution.

A preferred method of practicing the invention is to use photopolymer film laminated onto a support which upon exposure and development will provide a final end product such as a color proof or transparency, solder mask, printed circuit, printing plate, vias in photosensitive dielectric layers, etc.

### EXAMPLES

| | GLOSSARY |
|---|---|
| Alumina I: | 98.23% alumina, 1.77% cobalt aluminate which has been passed through a magnetic separator and freeze dried; d50 of 2.3-2.7 microns. |
| Frit II: | 40.2% SiO₂; 5.9% B₂O₃; 9.9% Al₂O₃; 8.0% PbO; 5.1% CaO; 8.04% ZnO; 5.0% MgO; 17.9% BaCO₃; d50 of 2.2-3.0 microns. |
| MMA | Methylmethacrylate |
| MAA | Methacrylic acid |

### Example 1:

A photosensitive dielectric layer on an alumina ceramic support was prepared using the following procedure.

A vehicle mixture was prepared first.

| INGREDIENT | PARTS BY WEIGHT |
|---|---|
| Copolymer MMA/MAA (75/25 by weight), MW= 7000, Acid No. = 160 | 40.00 |
| β-Terpineol | 54.90 |
| 2,6-Di-t-butyl-4-methyl phenol | 0.30 |
| Benzophenone | 4.00 |
| Michler's ketone | 0.80 |

The polymer and solvent β-terpineol were mixed and heated with stirring at 135°C. Heating and stirring was continued until the polymer had dissolved. The solution was cooled to 100°C and the rest of the components were added. The mixture was stirred until all solids had dissolved.

The photosensitive dielectric paste was then prepared by the following procedure:

| INGREDIENT | PARTS BY WEIGHT |
|---|---|
| Alumina I | 21.90 |
| Frit II | 28.60 |
| Quartz | 4.50 |
| Vehicle mixture | 31.00 |
| Polyoxyethylated trimethylolpropane triacrylate, MW=1162 | 8.48 |
| Trimethylolpropane triacrylate | 2.12 |
| AB Dispersant | 2.10 |
| β-Terpineol | 1.30 |

The dielectric paste was prepared by mixing the above mentioned components for 30 minutes. The mixture was roll milled using a three roll mill at roll pressure of 400 psi. The paste was screened through a 400 mesh screen. The viscosity was adjusted to 80-120 poise by adding β-terpineol. The paste was screen printed onto an alumina support using a 200 mesh screen. The part was dried at 75°C for 15 minutes, resulting a 25 micron thickness. The printing and drying steps were repeated to produce a total thickness of 50 microns.

Ink jet inks were prepared as described below:

### Ink 1 (Control):

Commercial ink cartridge for Hewlett Packard DeskJet ink jet printer (Hewlett Packard, Palo Alto, CA)

### Ink 2 (Control):

| INGREDIENT | WEIGHT % |
|---|---|
| Purified Food Black 2 dye, trimethylammonium salt | 5.0 |
| Diethylene glycol (Aldrich Chemical Co., Milwaukee, WI) | 5.0 |
| Liponics® EG-1 (Lipo Chemical Co., Patterson, NJ) | 5.0 |
| Deionized water | 85.0 |

The above mentioned components were mixed to give a homogeneous solution.

### Ink 3:

The polymeric dispersant was prepared using the following procedure:
A block copolymer of n-butyl methacrylate ("BMA") and methacrylic acid was prepared by adding 3750 grams of tetrahydrofuran and 7.4 grams of p-xylene to a 12-liter flask equipped with a mechanical stirrer, thermometer, nitrogen inlet, drying tube outlet and addition funnels. Feed I, which consisted of 3.0 ml of a 1.0 M solution of tetrabutyl ammonium m-chlorobenzoate catalyst in acetonitrile, was started at 0 minutes and added over 150 minutes and 291.1 gm (1.25 mole) of an initiator, 1,1-bis(trimethylsiloxy-2-methyl propene, was injected. Feed II, which consisted of 1976 gm (12.5 M) trimethylsilyl methacrylate, was started at 0 minutes and added over 35 minutes. One hundred eighty minutes after Feed II was completed (over 99% of the monomers had reacted), Feed III, which consisted of 1772 gm (12.5M) butyl methacrylate, was started and added over 30 minutes.

At 400 minutes, 780 grams of dry methanol were added to the above solution and distillation commenced. During the first stage of distillation, 1300.0 grams of material with a boiling point below 55°C were removed from the flask. The theoretical amount of methoxytrimethylsilane, having a boiling point below 54°C, to be removed was 1144.0 grams. Distillation continued during the second stage while the boiling point increased to 76°C. 5100 grams of isopropanol were added during the second stage of distillation. A total of 7427 grams of solvent were removed.

The resultant resin solution contained 55.8% solids. The resin was neutralized by adding to a 1000 ml cylindrical polyethylene bottle:
200.0 grams dispersant solution
174.4 grams 15% potassium hydroxide
137.6 grams deionized water
The mixture was tumbled on a roller mill for 3-4 hours and then magnetically stirred for 16-20 hours to give a slightly cloudy solution.

A black ink jet ink having the following composition was then prepared by the procedure similar to that described in the examples of U.S. Patent No. 5,085,698.

| INGREDIENT | WEIGHT % |
|---|---|
| FW18, Carbon Black Pigment (Degussa Corp., Allendale, NJ) | 5.0 |
| Block Polymer, BMA//MAA (10//10 by degree of polymerization), | 2.5 |
| Diethylene glycol | 5.0 |
| Liponics® EG-1 | 5.0 |
| Deionized water | 82.5 |

A 20 gram sample of each of Inks 1-3 was placed into the ink reservoir of a thermal ink jet pen. These pens were sequentially loaded on a DeskJet ink jet printer (Hewlett Packard Co., Palo Alto, CA) to print a few rows of single dot pattern on the same photosensitive dielectric element. All three inks produced high density, black, well shaped dots on the element. After drying, the dielectric element was exposed using a Du Pont PC Printer 130 exposing unit. The energy level was determined by an APM Digital Radiometer, Model 87 (American Pacific Marketing Co.). The elements were developed by a 30 psi sprayer using 0.8% sodium carbonate solution at 29°C for 25 seconds, rinsed with water and dried.

| EXPOSURE ENERGY | INK | RESULTS |
|---|---|---|
| 13 mj/cm² | Ink 1 (Control) | No vias. The black dot pattern was vaguely visible. |
| | Ink 2 (Control) | Well shaped 90 micron vias were obtained. However, they were smaller than the dots of the mask, indicating over exposure. |
| | Ink 3 | Perfectly round 130 micron vias with sharp edges were obtained. |
| 18 mj/cm² | Ink 1 | No vias. The black dot pattern was vaguely visible. |
| | Ink 2 | No vias. Mostly just a shallow depression, some vias began to develop. |
| | Ink 3 | Perfectly round 130 micron vias with sharp edges were obtained. |
| 33 mj/cm² | Ink 1 | No vias. The black dot pattern was vaguely visible. |
| | Ink 2 | No vias. The dot pattern changed to white color. |
| | Ink 3 | Perfectly round 110 micron vias with sharp edges were obtained. |
| 48 mj/cm² | Ink 1 | No vias. The black dot pattern was vaguely visible. |
| | Ink 2 | No vias. The dot pattern changed to white color |
| | Ink 3 | Perfectly round 100 micron vias with sharp edges were obtained. |

The pigmented ink (Ink 3) consistently showed far better effectiveness as a photomask than the dye-based controls (Inks 1 and 2) and over a greater latitude of exposing energy. The visible dot pattern of Ink 1 after exposure and development indicates a great deal of ink penetration into the dielectric layer. The photosensitive resin used in the paste formulation meets all the resin requirements set forth in the aforementioned (Kokai) 62-54253.

### Example 2:

A black ink jet ink (Ink 4) having the following composition was prepared as described in Example 1

| INGREDIENT | WEIGHT % |
|---|---|
| FW18, Carbon Black Pigment | 5.0 |
| Block Polymer, BMA//MAA | 2.5 |
| Diethylene glycol | 4.6 |
| Liponics® EG-1 | 4.6 |
| Silwet® L-77 (Union Carbide Corp., Danbury, CT) | 1.0 |
| Deionized water | 82.3 |

A photosensitive positive-working Cromalin® proofing film with a Mylar® cover sheet (both E.I. du Pont de Nemours & Co., Wilmington, DE), similar to that described in Example 3 of US Patent 3,854,950, was hot-roll laminated onto a sheet of PaintJet® paper (Hewlett Packard Co., Palo Alto, CA). A 20 gram sample of Ink 4 was filled into the ink reservoir of a thermal ink jet pen. The pen was loaded on a DeskJet ink jet printer (Hewlett Packard Co., Palo Alto, CA). Alphanumerical characters and dot patterns were printed onto the cover sheet. After the ink dried, the assembly was exposed for 9 seconds using a Douthitt Light Integrator-Magic 782 (Douthitt Corp., Detroit, MI). The cover sheet with the mask was removed and a black toner, similar to that described in Example 6 of US 5,039,588, was applied to the exposed photopolymer layer using a soft cotton rag and excess toner was removed to give a high density image. The dots had perfectly round shape with sharp edges. Similar results were obtained with magenta and cyan toners.

Inks 1 and 2 were used as controls. In both cases, the ink beaded up and coalesced into small ink pools on the cover sheet. The image features were completely lost.

### Example 3:

### A polymeric dispersant, Poly(ethoxytriethylene glycol methacrylate [3.8 units]-b-benzyl methacrylate [4.8 units]-b-2-dimethylaminoethyl methacrylate [9.5 units]) (DMAEMA//PEMA//ETEGMA), was prepared by the procedure outlined below:

To a solution of 11.04 g (63.3 mmol) of 1-methoxy-1-trimethylsiloxy-2-methyl-1-propene and 4 mL of tetrabutylammonium biacetate (0.1 M in propylene carbonate) in 200 mL THF was added 59.7 g (242.5 mmol) ethoxytri-ethylene glycol methacrylate (stored over 4 sieves for 7 days) dropwise over a period of 18 minutes. During the addition, the temperature rose from 29°C to 47°C. Then 1 mL of tetrabutylammonium biacetate (0.1 M in propylene carbonate) was added. When the temperature had fallen to 42°C, addition of 53.9 g (305.66 mmol) of benzyl methacrylate (purified by distillation) was begun. The addition required 24 minutes during which time the temperature rose to 51°C. When the temperature had fallen to 46°C, 1 mL of tetrabutylammonium biacetate (0.1 M in propylene carbonate) was added, and the addition of 94.6 g (601.45 mmol) of 2-dimethylaminoethyl

131.5 grams of deionized water
Ink 5 having the following composition was then prepared in the same manner as the previous examples.

| INGREDIENT | %WT |
|---|---|
| FW18, Carbon Black Pigment | 3.5 |
| Block Polymer, DMAEMA//PEMA//ETEGMA | 1.8 |
| Diethylene glycol | 4.7 |
| Liponics® EG-1 | 4.7 |
| Silwet® L-77 | 1.0 |
| Deionized water | 84.3 |

A nontacky photoresist with a cover sheet, similar to that described in U.S. 4,293,635, was hot-roll laminated on a sheet of Pyralux® copper-cald laminate (E.I. du Pont de Nemours & Co., Wilmington, DE). The cover sheet was

| | | |
|---|---|---|
| 160 mj/cm² | Ink 1: | The image was visible but not fully developed. |
| | Ink 5: | High resolution sharp image with fully cured background. |

The pigmented ink (Ink 5) produced an effective photomask which allowed for a wide latitude of exposure conditions. The dye-based control ink (Ink 1) could not withstand the radiation required to cure the composition.

## Claims

1. A process of photoimaging a photosensitive element comprising the steps of:
(a) applying a photosensitive layer to a support;
(b) generating an actinic radiation-opaque image layer on said photosensitive layer by ink jet printing, wherein said opaque image layer comprises a pigmented ink jet ink which does not react with or substantially penetrate into the photosensitive layer;
(c) exposing the photosensitive layer to actinic radiation through the opaque image layer; and
(d) developing the exposed photosensitive layer to form an image.

2. The process of Claim 1, wherein the support is selected from the group consisting of transparent films, opaque films and metal supports.

3. The process of Claim 1, wherein the photosensitive layer is selected from the group consisting of diazo, silver halide, photopolymer, dielectric and electrographic films.

4. The process of Claim 1, further comprising the step of applying a cover sheet to said photosensitive layer and wherein the actinic radiation opaque layer is generated on said cover sheet.

5. The process of Claim 4, wherein the cover sheet is selected from the group consisting of polyethylene terephthalate, regenerated cellulose, cellulose triacetate, polyethylene, polypropylene, polyamide, polyvinyl alcohol and polyacrylate.

6. The process of Claim 1, wherein the pigmented ink jet ink comprises a liquid carrier medium and a pigment dispersion.

7. The process of Claim 6, wherein the liquid carrier medium is an organic solvent.

8. The process of Claim 7, wherein the solvent is selected from the group consisting of alcohols, ketones, ethers, esters, aromatics and chlorinated solvents.

9. The process of Claim 6, wherein the liquid carrier medium comprises water or a mixture of water and at least one water soluble organic solvent.

10. The process of Claim 6, wherein the pigment dispersion comprises a pigment and a polymeric dispersing agent.

11. The process of Claim 10, wherein the pigment is carbon black.

12. The process of Claim 11, wherein the polymeric dispersing agent is selected from the group consisting of random polymers, block polymers and branched type polymers.

13. The process of Claim 1, wherein the pigmented ink jet ink has a viscosity below 10 cP at 20°C.

14. The process of Claim 1, wherein the pigmented ink jet ink has a surface tension of 25-70 dynes/cm at 20°C.

15. The process of Claim 1, wherein the pigmented ink comprises a surfactant.
